# EUROPEAN PATENT APPLICATION

(11) **EP 4 425 568 A1**
(43) Date of publication of application: **04.09.2024**
(21) Application number: 21966607.0
(22) Date of filing: 06.12.2021
(51) Int. Cl.: H01L 29/66, H01L 29/78, H01L 21/28

(54) **SEMICONDUCTOR CHIP AND MANUFACTURING METHOD THEREFOR, AND ELECTRONIC DEVICE**

(71) Applicant: Huawei Technologies Co., Ltd., Shenzhen, Guangdong 518129 (CN)
(72) Inventor: ZHANG, Kehao, Shenzhen, Guangdong 518129 (CN); LIU, Xi, Shenzhen, Guangdong 518129 (CN); YE, John, Shenzhen, Guangdong 518129 (CN); LIN, Jun, Shenzhen, Guangdong 518129 (CN)
(74) Representative: Maiwald GmbH
(86) International application number: PCT/CN2021/135679
(87) International publication number: WO 2023/102679

(57) **Abstract**

This application discloses a semiconductor chip, a production method therefor, and an electronic device. The semiconductor chip includes a substrate and a Fin FET located on the substrate. The Fin FET includes a fin, two sidewalls that extend across the fin and are arranged opposite to each other, and a gate structure located in a trench defined by the two sidewalls. The gate structure includes a gate dielectric layer and a gate metal layer that are stacked in sequence. The gate metal layer includes a TiSiN layer. To be specific, a TiSiN material is used to fill a gap. During filling with TiSiN, a lattice structure of TiN may be damaged due to doping of Si, so that a formed TiSiN thin film becomes an amorphous thin film, to prevent ahead-of-time sealing of a gap opening due to an excessively large grain size. Therefore, the TiSiN layer in the gate structure provided in this application has an excellent gap filling capability, and can implement seamless filling of a gap with a high depth-width ratio. In addition, TiSiN with a low silicon concentration has a resistivity similar to or even lower than that of TiN. Therefore, a low-resistivity gate structure can be implemented.

## Description

### TECHNICAL FIELD

This application relates to the field of semiconductor technologies, and in particular, to a semiconductor chip, a production method therefor, and an electronic device.

### BACKGROUND

With rapid development of the semiconductor integrated circuit (integrated circuit, IC) industry, the semiconductor industry has evolved into the nanometer technology node (node) to pursue higher apparatus density, higher efficiency, and lower costs. In the advanced logic process below 22 nm, a fin field-effect transistor (Fin Field-Effect Transistor, Fin FET) equipped with a high dielectric constant metal gate (high K metal gate, HKMG) technology is used as a transistor unit. Due to the unique 3D structure of the Fin FET, filling of a gate metal layer in a gate structure evolves from filling with aluminum (Al) by using a physical vapor deposition (Physical Vapor Deposition, PVD) method above 28 nm to filling with tungsten (W) by using a chemical vapor deposition (Chemical Vapor Deposition, CVD) method. As devices continuously scale down, the gate length continuously decreases, and conventional processes can no longer implement seamless filling of a gate metal layer. A gap in the gate metal layer causes high resistivity of a gate structure. Consequently, stability of a device is lowered. In addition, grinding fluid in a subsequent planarization process flows into a work function layer due to the existence of the gap in the gate metal layer, and as a result, changes electrical properties of the work function layer, affects a threshold voltage (Threshold voltage) of the device, and leads to drift of the threshold voltage.

### SUMMARY

This application provides a semiconductor chip, a production method therefor, and an electronic device, to implement seamless filling of a gate metal layer in a gate structure of the semiconductor chip.

According to a first aspect, this application provides a semiconductor chip, including a substrate and a Fin FET located on the substrate, where the Fin FET includes a fin, a gate structure, and two sidewalls that are arranged opposite to each other. The fin generally includes a source, a drain, and a channel located between the source and the drain. Both the two sidewalls extend across the fin, and a trench is formed between the two sidewalls. The gate structure is located in the trench between the two sidewalls. The gate structure may include a gate dielectric layer and a gate metal layer that are stacked in sequence. In an implementation, the gate dielectric layer is formed on side surfaces and a bottom surface of the trench, and the gate metal layer fills a gap defined by the gate dielectric layer. In the semiconductor chip, the gate metal layer includes a titanium silicon nitride (TiSiN) layer. When the gate metal layer includes only a TiSiN layer, that is, a TiSiN material is used to fill a gap, during filling with TiSiN, a lattice structure of TiN may be damaged due to doping of Si, so that a formed TiSiN thin film becomes an amorphous thin film. Because the amorphous thin film has a small grain size and low surface roughness, ahead-of-time sealing of a gap opening is prevented in nanometer scale due to an excessively large grain size. Therefore, the gate metal layer including the TiSiN layer according to this application has an excellent gap filling capability, and can implement seamless filling with a high depth-width ratio. In addition, TiSiN with a low silicon concentration has a resistivity similar to or even lower than that of TiN. Therefore, a low-resistivity gate structure can be implemented, thereby improving a gate control speed of the semiconductor chip and enhancing high-frequency working stability of the semiconductor chip.

In this application, the "depth-width ratio" refers to a ratio of a depth of a trench to a length of the trench in a channel direction. For example, the high depth-width ratio in this application means that the ratio of a depth of a trench to a length of the trench in the channel direction is between 50:1 and 100:1.

It should be noted that, in this application, that a plurality of film layers are "stacked" means that the plurality of film layers are formed layer by layer in a direction perpendicular to a surface of a base on which the plurality of film layers are to be formed. For example, in this application, the gate structure is provided in the trench, the side surfaces and bottom of the trench are used as a base of the gate structure, and the gate dielectric layer and the gate metal layer in the gate structure being stacked means that the gate dielectric layer and the gate metal layer are formed layer by layer in a direction perpendicular to the side surfaces of the trench and a direction perpendicular to the bottom of the trench.

For example, in this application, the gate structure may further include a work function layer. The work function layer is located between the gate dielectric layer and the gate metal layer. In other words, the work function layer is formed on side surfaces and a bottom surface of the gate dielectric layer, and the gate metal layer fills a gap defined by the work function layer. Because the gate metal layer in this application can implement seamless filling, grinding fluid in a subsequent planarization process can be prevented from flowing into the work function layer, thereby preventing drift of a threshold voltage of the semiconductor chip.

In this application, there may be one or more work function layers, and the work function layer is used for adjusting a work function value of the Fin FET, so that a formed transistor reaches an expected threshold voltage. For example, for a P-type field-effect transistor, the work function layer includes a P-type work function material, and the P-type work function material may be configured to have an expected work function value for use in a gate structure of the P-type field-effect transistor. For an N-type field-effect transistor, the work function layer includes an N-type work function material, and the P-type work function material may be configured to have an expected work function value for use in a gate structure of the N-type field-effect transistor.

In specific implementation, to form a semiconductor chip, a plurality of Fin FETs are usually formed on a substrate, and then the semiconductor chip needed is formed by cutting. When the plurality of Fin FETs are formed, fins in different Fin FETs usually need to be isolated by using a dielectric layer. Therefore, the semiconductor chip may further include a first dielectric layer and a second dielectric layer. The first dielectric layer is located between the gate structure and the substrate and covers a surface of the substrate and a part of each side surface of the fin. The second dielectric layer is located above the first dielectric layer, and the second dielectric layer covers side surfaces and a top of the fin that are exposed at outer sides of the sidewalls. In other words, the second dielectric layer covers side surfaces and a top of the source and side surfaces and a top of the drain.

In this application, the source and the drain are respectively located on two sides of two sidewalls, a channel is located between the source and the drain, and the gate structure covers a top and side surfaces of the channel. For example, the gate dielectric layer is formed on the top and side surfaces of the channel, and is formed on side surfaces of the sidewalls and a part of a surface of the first dielectric layer. The work function layer is formed on side surfaces and an upper surface of the gate dielectric layer. The gate metal layer fills a gap defined by side surfaces and an upper surface of the work function layer.

In specific implementation, in the TiSiN layer, excessively high content of silicon (Si) atoms causes high resistivity of the TiSiN layer, and excessively low content of Si atoms causes oxidation of the formed TiSiN layer and leads to formation of a gap. For example, in the TiSiN layer, Si %/(Si % + Ti %) ≤ 10%, where Si % represents a percentage of atomic concentration of Si in the TiSiN layer, and Ti % represents a percentage of atomic concentration of titanium (Ti) in the TiSiN layer. The percentage of atomic concentration can be obtained by scan analysis using a transmission electron microscope (Transmission Electron Microscope, TEM) and an energy dispersive spectrometer (Energy Dispersive Spectrometer, EDS) in combination.

Further, in this application, 0.8 ≤ (Si % + Ti %)/N % <_ 1.3 in the TiSiN layer, where N % represents a percentage of atomic concentration of silicon (N) in the TiSiN layer. Similarly, the percentage of atomic concentration can be obtained by scan analysis using a transmission electron microscope (Transmission Electron Microscope, TEM) and an energy dispersive spectrometer (Energy Dispersive Spectrometer, EDS) in combination. For example, in this application, Si % + Ti % = N %.

For example, the gate structure may further include a cover layer located between the gate dielectric layer and the work function layer as well as a barrier layer located between the cover layer and the work function layer. To be specific, the gate dielectric layer covers the top and side surfaces of the channel, the cover layer covers the side surfaces and the upper surface of the gate dielectric layer, the barrier layer covers side surfaces and an upper surface of the cover layer, the work function layer covers side surfaces and an upper surface of the barrier layer, and the gate metal layer fills the gap defined by the side surfaces and the upper surface of the work function layer. The cover layer is generally used for protecting quality of the gate dielectric layer from being affected by another subsequent process, and the barrier layer is generally used as an etching barrier layer of the work function layer. The cover layer may be formed by a deposition process by using a material such as titanium nitride (TiN) or TiSiN, and the barrier layer may be formed by a deposition process by using a material such as tantalum nitride (TaN).

For example, in this application, the gate dielectric layer may be formed by a deposition process such as chemical vapor deposition, plasma enhanced chemical vapor deposition, atomic layer deposition, or another suitable deposition process by using a material such as hafnium oxide (HfO₂), zirconium oxide (ZrO₂), hafnium zirconium oxide (HfZrO₂), aluminum oxide (Al₂O₃), or silicon dioxide (SiO₂).

Optionally, the gate dielectric layer may further include a dipole layer, where the dipole layer includes element lanthanum (La) and element aluminum (Al).

In specific implementation, there may be one or more work function layers. The work function layer is used for adjusting a work function value of the Fin FET, so that the formed transistor reaches an expected threshold voltage. For example, for a P-type field-effect transistor, the work function layer includes a P-type work function material, and the P-type work function material may be configured to have an expected work function value for use in a gate structure of the P-type field-effect transistor. For an N-type field-effect transistor, the work function layer includes an N-type work function material, and the P-type work function material may be configured to have an expected work function value for use in a gate structure of the N-type field-effect transistor.

For example, the work function layer may be formed by using at least one material in titanium nitride (TiN), titanium aluminum carbide (TiAlC), titanium aluminum nitride (TiAlN), and TiSiN. The work function layer may be formed by, for example, physical vapor deposition, chemical vapor deposition, plasma enhanced chemical vapor deposition, atomic layer deposition, or another suitable deposition process.

It should be noted that the gate structure provided in embodiments of this application is applicable to both a short-channel FET and a long-channel FET. For the short-channel FET, because a channel is short, using a TiSiN layer as a gate metal layer can not only implement gap-free filling, but also implement low resistivity of a gate structure.

For the long-channel FET, in a gate structure, a gate metal layer may further include a metal filling layer located in a gap defined by a titanium silicon nitride layer. In this way, during production, a process of the long-channel FET and a process of the short-channel FET can be both used, so that after the gate structure of the short-channel FET is formed, the metal filling layer continues to fill a trench of the long-channel FET, to complete production of the gate structure of the long-channel FET.

For example, a material of the metal filling layer may include tungsten, cobalt, or ruthenium, and is not limited herein.

It may be understood that, in this application, the short-channel FET means that a channel length of the FET is less than or equal to 30 nm, and the long-channel FET means that a channel length of the FET is greater than or equal to 100 nm. The channel length generally refers to the length of a channel in the direction from a source to a drain.

In this application, the length of the trench in the channel direction limits the length of the gate structure, and the length of the gate structure is usually approximately equal to the length of the channel.

In the semiconductor chip provided in this application, both a short-channel Fin FET and a long-channel Fin FET may be provided. To be specific, the semiconductor chip includes a first Fin FET and a second Fin FET, where the first Fin FET is a short-channel FET, and the second Fin FET is a long-channel FET.

In this application, a channel length of the first Fin FET is less than or equal to 30 nm, and a channel length of the second Fin FET is greater than or equal to 100 nm.

For example, the channel length of the first Fin FET may be controlled to be between 18 nm and 30 nm, and the channel length of the second Fin FET may be controlled between 100 nm and 300 nm.

For example, a gate structure of the first Fin FET includes a gate dielectric layer, a work function layer, and a TiSiN layer. A gate structure of the second Fin FET includes a gate dielectric layer, a work function layer, a TiSiN layer, and a metal filling layer. To be specific, in the gate structure of the first Fin FET, gap-free filling of the gate metal layer is implemented by using the TiSiN layer, and in the gate structure of the second Fin FET, gap-free filling of the gate metal layer is implemented by using the TiSiN layer and the metal filling layer.

Optionally, the TiSiN layer in the gate metal layer in the gate structure of the second Fin FET is formed by a same material as the TiSiN layer in the gate metal layer in the gate structure of the first Fin FET. In this way, during production, the TiSiN layer in the gate metal layer of the second Fin FET and the TiSiN layer in the gate metal layer of the first Fin FET may be formed in a same process, thereby reducing process steps.

For example, in the gate structure of the second Fin FET, a material of the metal filling layer in the gate metal layer may include tungsten, cobalt, or ruthenium, and is not limited herein.

According to a second aspect, this application further provides an electronic device. The electronic device includes a circuit board and a semiconductor chip. The semiconductor chip is the semiconductor chip according to any one of the first aspect or the implementations of the first aspect. The semiconductor chip is electrically connected to the circuit board. A problem-resolving principle of the electronic device is similar to that of the foregoing semiconductor chip. Therefore, for implementation of the electronic device, refer to the implementation of the foregoing semiconductor chip. Details are not described herein again.

For a technical effect that may be achieved in the second aspect, refer to the descriptions of the technical effect that may be achieved in any possible design in the foregoing first aspect. Details are not described herein again.

According to a third aspect, this application further provides a semiconductor chip production method. The production method may include: forming, on a substrate, a fin and two sidewalls that extend across the fin and are arranged opposite to each other; next, forming a gate dielectric layer on side surfaces and a bottom surface of a trench defined by the two sidewalls; and finally forming a gate metal layer in a gap defined by the gate dielectric layer, where the gate metal layer includes a titanium silicon nitride layer.

Optionally, in specific implementation, after the gate dielectric layer is formed, a work function layer may be further formed on side surfaces and a bottom surface of the gate dielectric layer, so that the gate metal layer is subsequently formed in the gap defined by the gate dielectric layer.

In a feasible implementation, a substrate on which the gate metal layer is to be formed may be placed in an atomic layer deposition chamber, a precursor of titanium and a precursor of nitrogen are alternately provided into the atomic layer deposition chamber, and a precursor of silicon is continuously provided into the atomic layer deposition chamber, to form a titanium silicon nitride layer in a gap defined by the work function layer. For example, the substrate on which the gate metal layer is to be formed is placed in the atomic layer deposition chamber, and the titanium silicon nitride layer may be formed, through at least one process cycle, in the gap defined by the work function layer. One process cycle may include four stages T1 to T4. At stage T1, the precursor of titanium (Ti) is provided into the atomic layer deposition chamber. At stage T2, the precursor of Ti is removed from the atomic layer deposition chamber. In specific implementation, the precursor of Ti may be removed from the atomic layer deposition chamber by gas extraction. At stage T3, the precursor of nitrogen (N) is provided into the atomic layer deposition chamber. At stage T4, the precursor of N is removed from the atomic layer deposition chamber. In specific implementation, the precursor of N may be removed from the atomic layer deposition chamber by gas extraction. In addition, in a process cycle, that is, at stage T1 to stage T4, the precursor of Si is continuously provided into the atomic layer deposition chamber.

It should be noted that, in this application, in a process cycle, T1 and T2 as well as T3 and T4 are exchangeable in sequence. To be specific, stage T3 and stage T4 may be first performed before stage T1 and stage T2 are performed.

For example, in this application, a flow rate of the precursor of Si flowing into the atomic layer deposition chamber may be set to be less than or equal to 20% of that of the precursor of Ti, to ensure that content of Si in formed TiSiN is low.

In this embodiment, during forming of the TiSiN layer, the precursor of Si flows in continuously. Because the precursor of Si is a reducing gas, if Cl exists in the precursor of Ti, the reducing gas that continuously flows in can effectively reduce Cl in the precursor of Ti, thereby reducing resistivity of the TiSiN layer.

In another feasible implementation, a substrate on which a gate metal layer is to be formed may be placed in an atomic layer deposition chamber, and a precursor of titanium, a precursor of nitrogen, and a precursor of silicon are provided into the atomic layer deposition chamber, to form a titanium silicon nitride layer in a gap defined by the work function layer. In specific implementation, the TiSiN layer may be formed, through at least one process cycle, in the gap defined by the work function layer. One process cycle may include at least one first process sub-cycle P1 and one second process sub-cycle P2 after the at least one process sub-cycle.

For example, in this application, one first process sub-cycle P1 may include four stages T1 to T4. At stage T1, the precursor of Ti is provided into the atomic layer deposition chamber. At stage T2, the precursor of Ti is removed from the atomic layer deposition chamber. In specific implementation, the precursor of Ti may be removed from the atomic layer deposition chamber by gas extraction. At stage T3, the precursor of N is provided into the atomic layer deposition chamber. At stage T4, the precursor of N is removed from the atomic layer deposition chamber. In specific implementation, the precursor of N may be removed from the atomic layer deposition chamber by gas extraction.

It should be noted that, in a first process sub-cycle P1, T1 and T2 as well as T3 and T4 are exchangeable in sequence. To be specific, stage T3 and stage T4 may be first performed before stage T1 and stage T2 are performed.

For example, in this application, one second process sub-cycle P2 may include: providing the precursor of Si into the atomic layer deposition chamber.

It may be understood that the "precursor" in this application is a precursor or a raw material for synthesizing a target substance (that is, TiSiN), that is, an atomic layer deposition reaction source.

For example, the precursor of Ti may include at least one of titanium tetrachloride (TiCl₄), tetrakis (dimethylamino)titanium (C₂H₇NTi, TDMAT), or tetrakis (diethylamido)titanium (C₁₆H₄₀N₄Ti, TDEAT). The precursor of Si may include at least one of silane (SiH₄), disilane (Si₂H₆), dichlorosilane (SiH₂Cl, DCS), or hexachlorodisilane (Si₂Cl₆, HCD). The precursor of N may include at least one of ammonia (NH₃), nitrogen (N₂), nitrogen (N₂)-H₂ plasma, NH₃ plasma, or N₂ plasma.

In this application, duration of each stage in a process cycle needs to be configured based on an actual component and specific process conditions, and is not limited herein.

In this application, when the Fin FET to be formed is a short-channel FET, the gate metal layer includes only a TiSiN layer. In other words, the gap defined by the work function layer is completely filled with the TiSiN layer. When the Fin FET to be formed is a long-channel FET, forming the gate metal layer in the gap defined by the work function layer may further include: after a titanium silicon nitride layer is formed, forming a metal filling layer in the gap defined by the titanium silicon nitride layer. In other words, the gate metal layer includes the TiSiN layer and the metal filling layer.

### BRIEF DESCRIPTION OF DRAWINGS

FIG. 1 is a schematic diagram of a three-dimensional structure of a Fin FET;
FIG. 2 is a schematic diagram of a structure of a Fin FET in which no gate structure is provided according to an embodiment of this application;
FIG. 3 is a schematic diagram of a structure of the Fin FET shown in FIG. 2 in which a gate structure is provided;
FIG. 4a is a schematic diagram of a cross-sectional structure of the Fin FET shown in FIG. 3 in direction AA';
FIG. 4b is a schematic diagram of a cross-sectional structure of the Fin FET shown in FIG. 3 in direction BB';
FIG. 5 is a schematic diagram of a cross-sectional structure of another gate structure according to an embodiment of this application;
FIG. 6 is a schematic diagram of a cross-sectional structure of still another gate structure according to an embodiment of this application;
FIG. 7 is a schematic flowchart of a semiconductor chip production method according to an embodiment of this application;
FIG. 8a to FIG. 8j are schematic diagrams of a three-dimensional structure of a semiconductor chip production process according to an embodiment of this application;
FIG. 9 is a schematic sequence diagram of a process cycle during forming of a TiSiN layer according to this application;
FIG. 10 is a schematic sequence diagram of another process cycle during forming of a TiSiN layer according to this application;
FIG. 11 is a schematic diagram of a cross-sectional structure of a semiconductor chip according to an embodiment of this application; and
FIG. 12a to FIG. 12c are schematic diagrams of a three-dimensional structure of a semiconductor chip production process according to an embodiment of this application.

Descriptions of reference numerals:

| | | | |
|---|---|---|---|
| 10 | Substrate; | 20' | Initial fin; |
| 20 | Fin; | 21 | Source; |
| 22 | Drain; | 23 | Channel; |
| 30 | First dielectric layer; | 40' | Sidewall material layer; |
| 40 | Sidewall; | 60 | Second dielectric layer; |
| 50, 50a, 50b | Gate structure; | 50' | Sacrificial gate; |
| 51, 151, 251 | Gate dielectric layer; | 52, 152, 252 | Work function layer; |
| 53, 153, 253 | TiSiN layer; | 54 | Cover layer; |
| 55 | Barrier layer; | 100 | Fin FET; |
| 100a | First Fin FET; | 100b | Second Fin FET; |
| V1 | Trench. | | |

### DESCRIPTION OF EMBODIMENTS

To make the objectives, technical solutions, and advantages of this application clearer, the following further describes this application in detail with reference to the accompanying drawings. However, example embodiments may be implemented in a plurality of forms and should not be construed as being limited to embodiments described herein. On the contrary, these embodiments are provided such that this application is more comprehensive and complete and fully conveys the concept of the example embodiments to a person skilled in the art. Identical reference numerals in the accompanying drawings denote identical or similar structures. Therefore, repeated description thereof is omitted. Expressions of positions and directions in this application are described by using the accompanying drawings as examples. However, changes may also be made as required, and all the changes fall within the protection scope of this application. The accompanying drawings in this application are merely used to illustrate relative position relationships and do not represent an actual scale.

It should be noted that specific details are set forth in the following descriptions for ease of fully understanding this application. However, this application can be implemented in a plurality of manners different from those described herein, and a person skilled in the art can perform similar generalization without departing from the connotation of this application. Therefore, this application is not limited to the following disclosed specific embodiments. The following descriptions of this specification are example implementations of this application. However, the descriptions are intended to describe the general principle of this application, and are not intended to limit the scope of this application. The protection scope of this application shall be defined by the appended claims.

To facilitate understanding of a semiconductor chip, a production method therefor, and an electronic device that are provided in embodiments of this application, the following first describes an application scenario of the semiconductor chip, the production method therefor, and the electronic device.

In the semiconductor chip having a Fin FET provided in embodiments of this application, a gate structure is provided to cover a channel, so that ideal control of the channel can be implemented. Therefore, the semiconductor chip provided in embodiments of this application is widely applicable to various electronic devices, such as a logic device or a storage device. It should be noted that the semiconductor chip provided in embodiments of this application is intended to be used in electronic devices including but not limited to the foregoing electronic devices and any other electronic device of a suitable type.

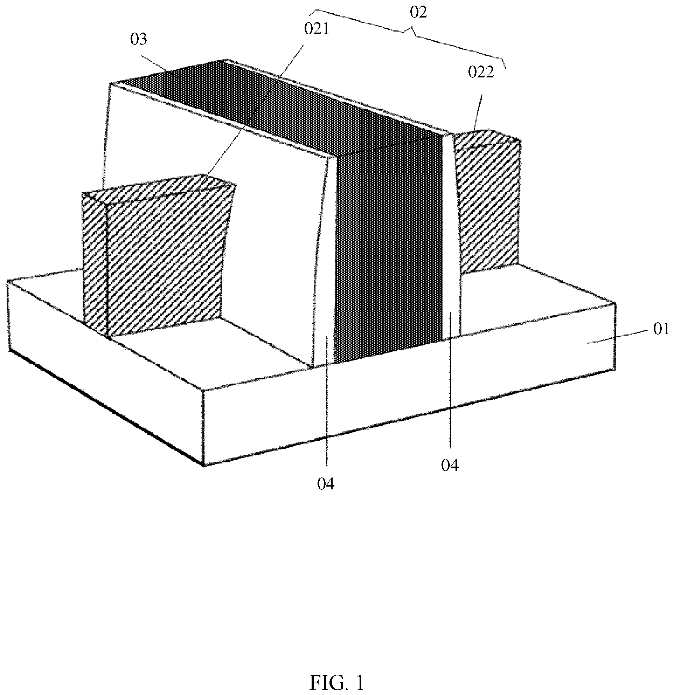

The Fin FET is a common multi-gate device. FIG. 1 is a schematic diagram of a three-dimensional structure of a Fin FET. As shown in FIG. 1, the Fin FET is disposed on a semiconductor substrate 01. The Fin FET includes a fin 02 provided on the semiconductor substrate 01, where the fin 02 includes a source 021, a drain 022, and a channel (not shown in FIG. 1) located between the source 021 and the drain 022; a gate structure 03 that extends across the fin 02 and covers a top and side surfaces of the channel; and two sidewalls 04 arranged opposite to each other on two sides of the gate structure 03. For the Fin FET, because the gate structure 03 covers the top and the side surfaces on two sides of the channel, a drive current of the FET is increased, and device performance is improved.

In specific implementation, the gate structure is formed in a trench defined by the sidewalls, and the gate structure is usually formed by stacking a gate dielectric layer, a work function layer, and a tungsten filling layer. However, as devices continuously scale down, the gate length (the width of the trench) continuously decreases, and a gap formed in the tungsten filling layer causes high resistivity of the gate structure and low stability of a device. In addition, grinding fluid in a subsequent planarization process flows into the work function layer due to the existence of the gap in the tungsten filling layer, and as a result, changes electrical properties of the work function layer, and leads to a problem such as drift of the threshold voltage of the device.

In a related technology, the gate structure is filled with aluminum titanium silicon nitride (TiAlN) instead of W. However, resistivity of TiAlN increases exponentially with an increase in content of aluminum (Al). Consequently, resistance of the gate structure increases, and a device rate decreases. In addition, in a TiAlN process, particles are formed due to generation of an Al-C compound. This is not conducive to mass production.

In view of this, an embodiment of this application provides a gate structure that can reduce resistivity and implement seamless filling. The following further describes in detail this application with reference to accompanying drawings.

Terms used in the following embodiments are merely intended to describe specific embodiments, but are not intended to limit this application. The singular expression "one", "a/an", "said", "the foregoing", "the" and "this" as used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiment or embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

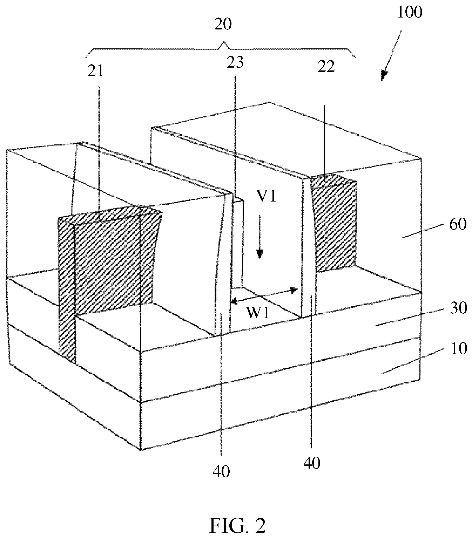

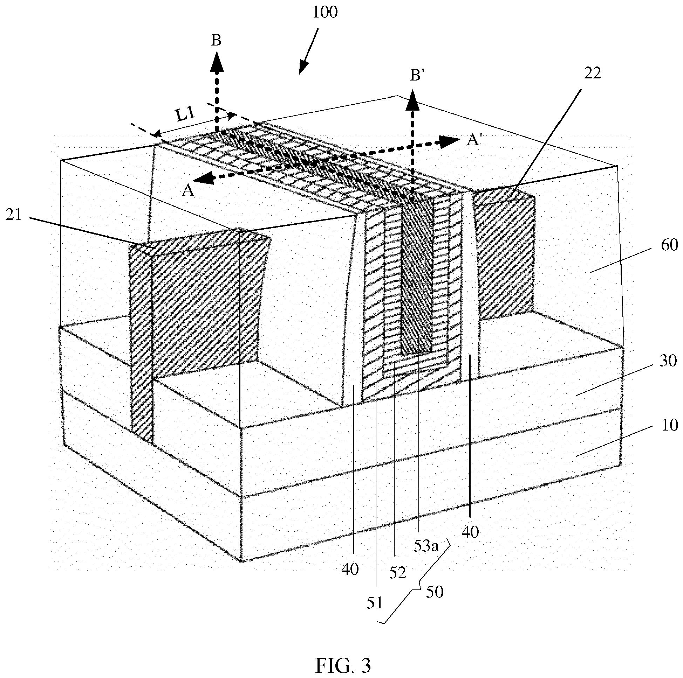

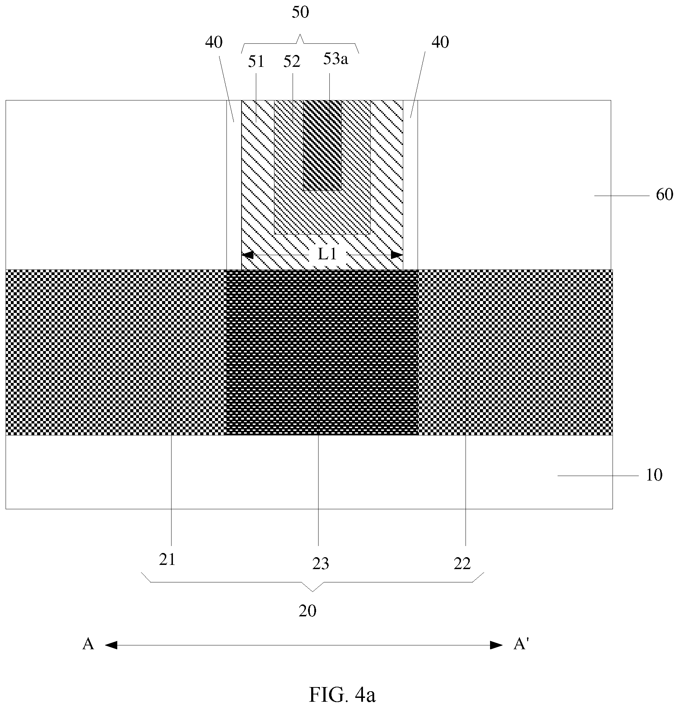

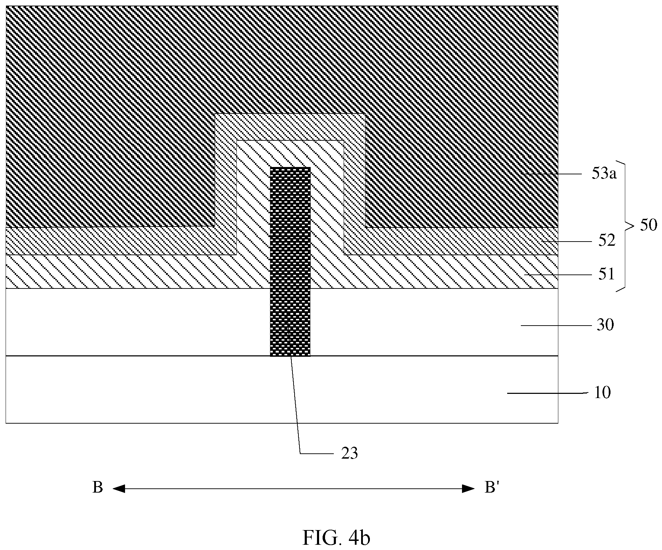

Refer to FIG. 2 to FIG. 4b. FIG. 2 is a schematic diagram of a structure of a Fin FET in which no gate structure is provided according to an embodiment of this application. FIG. 3 is a schematic diagram of a structure of the Fin FET shown in FIG. 2 in which a gate structure is provided. FIG. 4a is a schematic diagram of a cross-sectional structure of the Fin FET shown in FIG. 3 in direction AA'. FIG. 4b is a schematic diagram of a cross-sectional structure of the Fin FET shown in FIG. 3 in direction BB'. In the semiconductor chip provided in this embodiment of this application, a Fin FET 100 is provided on a substrate 10. The Fin FET 100 includes a fin 20, two sidewalls 40 that extend across the fin 20 and are arranged opposite to each other, and a gate structure 50 located in a trench V1 defined by the two sidewalls 40. The gate structure 50 may include: a gate dielectric layer 51 and a gate metal layer that are stacked in sequence. The gate metal layer includes a titanium silicon nitride (TiSiN) layer 53a. In an implementation, the gate dielectric layer 51 is formed on side surfaces and a bottom surface of the trench, and the gate metal layer fills a gap defined by the gate dielectric layer 51. In the semiconductor chip, the gate metal layer includes the TiSiN layer 53a, that is, a TiSiN material is used to fill the gap. During filling with TiSiN, a lattice structure of TiN may be damaged due to doping of Si, so that a formed TiSiN thin film becomes an amorphous thin film. Because the amorphous thin film has a small grain size and low surface roughness, ahead-of-time sealing of a gap opening is prevented in nanometer scale due to an excessively large grain size. Therefore, the TiSiN layer in the gate structure provided in this application has an excellent gap filling capability, and can implement seamless filling of a gap with a high depth-width ratio (that is, a ratio of a depth of a trench to a length of the trench in a channel direction). For example, the depth-width ratio is between 50:1 and 100:1. In addition, TiSiN with a low silicon concentration has a resistivity similar to or even lower than that of TiN. Therefore, a low-resistivity gate structure can be implemented, thereby improving a gate control speed of the semiconductor chip and enhancing high-frequency working stability of the semiconductor chip.

It should be noted that, in this application, that a plurality of film layers are "stacked" means that the plurality of film layers are formed layer by layer in a direction perpendicular to a surface of a base on which the plurality of film layers are to be formed. For example, in this application, the gate structure is provided in the trench, the side surfaces and bottom of the trench are used as a base of the gate structure, and the gate dielectric layer and the gate metal layer in the gate structure being stacked means that the gate dielectric layer and the gate metal layer are formed layer by layer in a direction perpendicular to the side surfaces of the trench and a direction perpendicular to the bottom of the trench.

For example, in this application, as shown in FIG. 3, the gate structure 50 may further include a work function layer 52. The work function layer 52 is located between the gate dielectric layer 51 and the gate metal layer. To be specific, the work function layer 52 is formed on side surfaces and a bottom surface of the gate dielectric layer 51, the gate metal layer fills a gap defined by the work function layer 52, and the gate metal layer is isolated from the gate dielectric layer 51 by the work function layer 52. Because the gate metal layer in this application can implement seamless filling, grinding fluid in a subsequent planarization process can be prevented from flowing into the work function layer, thereby preventing drift of a threshold voltage of the semiconductor chip.

In this application, there may be one or more work function layers, and the work function layer is used for adjusting a work function value of the Fin FET, so that a formed transistor reaches an expected threshold voltage. For example, for a P-type field-effect transistor, the work function layer includes a P-type work function material, and the P-type work function material may be configured to have an expected work function value for use in a gate structure of the P-type field-effect transistor. For an N-type field-effect transistor, the work function layer includes an N-type work function material, and the P-type work function material may be configured to have an expected work function value for use in a gate structure of the N-type field-effect transistor.

In this application, the fin 20 usually includes a source 21, a drain 22, and a channel 23. The source 21 and the drain 22 are respectively located on two sides of the two sidewalls 40. The channel 23 is located between the source 21 and the drain 22. The gate structure 50 covers a top and side surfaces of the channel 23. For example, as shown in FIG. 4a and FIG. 4b, the gate dielectric layer 51 is formed on the top and side surfaces of the channel 23, and is formed on side surfaces of the sidewalls 40 and a part of a surface of the first dielectric layer 30. The work function layer 52 is formed on side surfaces and an upper surface of the gate dielectric layer 51. The gate metal layer fills the gap defined by the side surfaces and the upper surface of the work function layer 52.

In specific implementation, to form a semiconductor chip, a plurality of Fin FETs are usually formed on a substrate, and then the semiconductor chip needed is formed by cutting. When the plurality of Fin FETs are formed, fins in different Fin FETs usually need to be isolated by using a dielectric layer. Therefore, further, as shown in FIG. 2 and FIG. 3, a first dielectric layer 30 and a second dielectric layer 60 are usually further provided in the semiconductor chip. The first dielectric layer 30 is located between the gate structure 50 and the substrate 10, and covers a surface of the substrate 10 and a part of each side surface of the fin 20. The second dielectric layer 60 is located above the first dielectric layer 30, and the second dielectric layer 60 covers side surfaces and a top of the fin 20 that are exposed at outer sides of the sidewalls 40. In other words, the second dielectric layer 60 covers side surfaces and a top of the source 21 and side surfaces and a top of the drain 22.

In specific implementation, in the TiSiN layer, excessively high content of silicon (Si) atoms causes high resistivity of the TiSiN layer, and excessively low content of Si atoms causes oxidation of the formed TiSiN layer and leads to formation of a gap. For example, in the TiSiN layer, Si %/(Si % + Ti %) ≤ 10%, where Si % represents a percentage of atomic concentration of Si in the TiSiN layer, and Ti % represents a percentage of atomic concentration of titanium (Ti) in the TiSiN layer. The percentage of atomic concentration can be obtained by scan analysis using a transmission electron microscope (Transmission Electron Microscope, TEM) and an energy dispersive spectrometer (Energy Dispersive Spectrometer, EDS) in combination.

Further, in this application, 0.8 ≤ (Si % + Ti %)/N % <_ 1.3 in the TiSiN layer, where N % represents a percentage of atomic concentration of silicon (N) in the TiSiN layer. Similarly, the percentage of atomic concentration can be obtained by scan analysis using a transmission electron microscope (Transmission Electron Microscope, TEM) and an energy dispersive spectrometer (Energy Dispersive Spectrometer, EDS) in combination. For example, in this application, Si % + Ti % = N %.

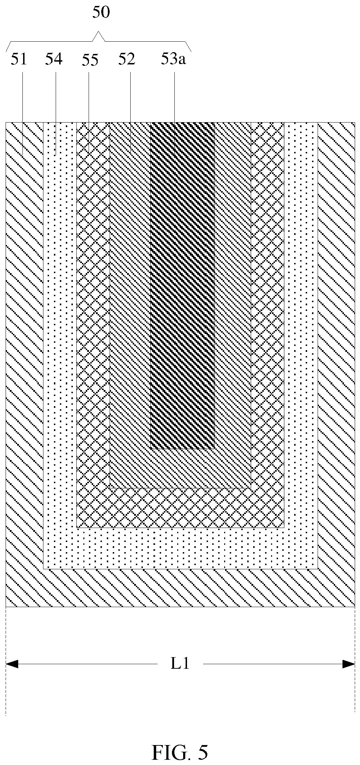

For example, FIG. 5 is a schematic diagram of a cross-sectional structure of a gate structure according to an embodiment of this application. The gate structure 50 may further include a cover layer 54 located between the gate dielectric layer 51 and the work function layer 52 as well as a barrier layer 55 located between the cover layer 54 and the work function layer 52. To be specific, the gate dielectric layer 51 covers the top and side surfaces of the channel 23. The cover layer 54 covers the side surfaces and upper surface of the gate dielectric layer 51. The barrier layer 55 covers side surfaces and an upper surface of the cover layer 54. The work function layer 52 covers side surfaces and an upper surface of the barrier layer 55. The gate metal layer fills the gap defined by the side surfaces and the upper surface of the work function layer 52. The cover layer 54 is generally used for protecting quality of the gate dielectric layer 51 from being affected by another subsequent process, and the barrier layer 55 is generally used as an etching barrier layer of the work function layer 52. The cover layer 54 may be formed by a deposition process by using a material such as titanium nitride (TiN) or TiSiN, and the barrier layer 55 may be formed by a deposition process by using a material such as tantalum nitride (TaN).

It should be noted that the Fin FET provided in embodiments of this application is applicable to both a short-channel FET and a long-channel FET. For the short-channel FET, because a channel is short, using a TiSiN layer as a gate metal layer can not only implement gap-free filling, but also implement low resistivity.

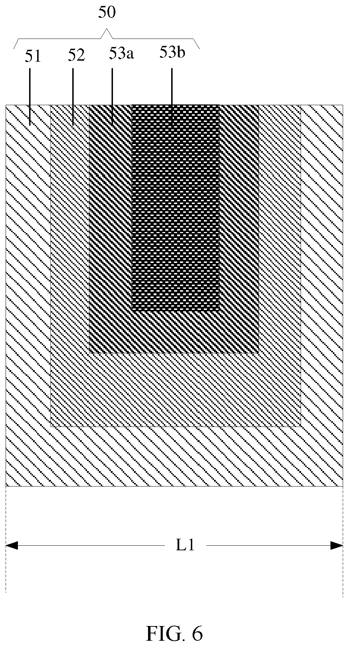

For a long-channel FET, refer to FIG. 6. FIG. 6 is a schematic diagram of a cross-sectional structure of another gate structure according to an embodiment of this application. In the gate structure, the gate metal layer may further include a metal filling layer 53b located in a gap defined by a titanium silicon nitride layer 53a. In this way, during production, a process of the long-channel FET and a process of the short-channel FET can be both used, so that after the gate structure of the short-channel FET is formed, the metal filling layer 53b continues to fill a trench of the long-channel FET, to complete production of the gate structure of the long-channel FET.

For example, a material of the metal filling layer may include tungsten, cobalt, or ruthenium, and is not limited herein.

It may be understood that, in this application, the short-channel FET means that a channel length of the FET is less than or equal to 30 nm, and the long-channel FET means that a channel length of the FET is greater than or equal to 100 nm. The channel length generally refers to the length of a channel in the direction from a source to a drain.

As shown in FIG. 2, in this application, a length W1 of the trench V1 in a direction of the channel 23 limits a length L1 of the gate structure 50, and the length L1 of the gate structure 50 is usually approximately equal to the length of the channel 23.

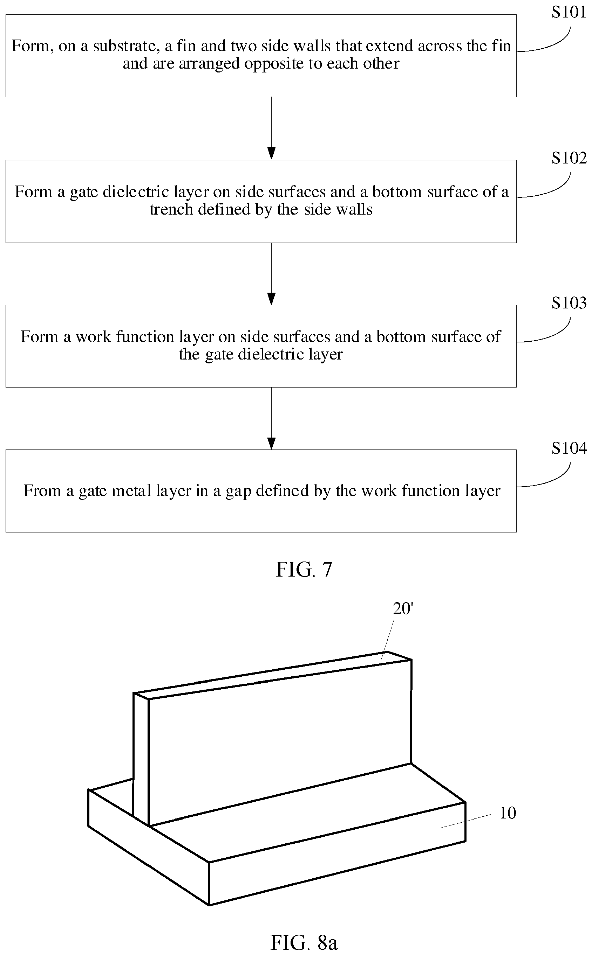

FIG. 7 is a schematic flowchart of a semiconductor chip production method according to an embodiment of this application. As shown in FIG. 7, the production method may include the following steps.

Step S101: Form, on a substrate, a fin and two sidewalls that extend across the fin and are arranged opposite to each other.

Refer to FIG. 8a. An initial fin 20' is formed on the substrate 10, where the initial fin 20' may be formed by epitaxy on the substrate 10, or may be formed by etching the substrate 10. This is not limited herein.

The substrate may be formed by a material such as silicon, a III-semiconductor material, an IV-semiconductor material, or a V-semiconductor material. The initial fin 20' may be formed by a semiconductor material such as Si, germanium (Ge), silicon germanium (SiGe), a III-semiconductor material, or a V-semiconductor material.

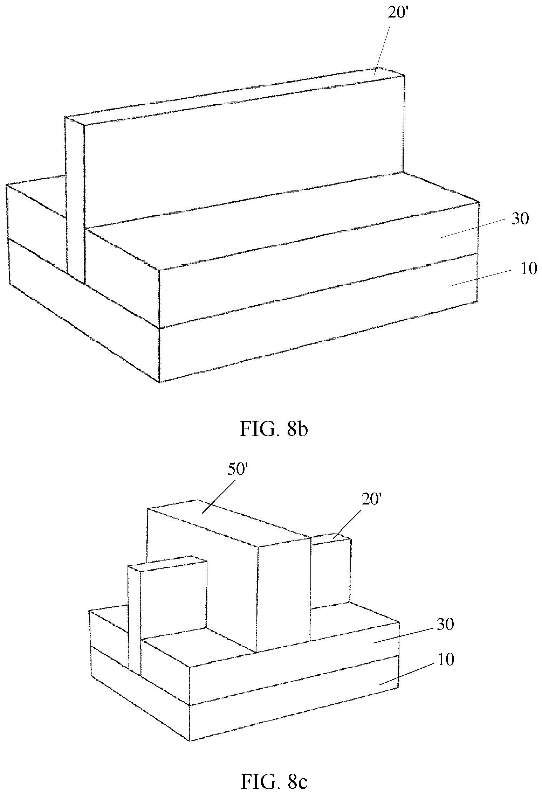

Refer to FIG. 8b. A first dielectric layer 30 is formed on a surface of the substrate 10. A thickness of the first dielectric layer 30 is less than a thickness of the initial fin 20'.

The first dielectric layer may be formed by deposition using a dielectric material such as one or a combination of silicon monoxide (SiO), silicon nitride (SiN), or silicon oxynitride (SiON).

Refer to FIG. 8c. A sacrificial gate 50' extending across the initial fin 20' is formed.

The sacrificial gate 50' may be formed by deposition using a suitable material such as polycrystalline silicon or amorphous silicon. This is not limited herein.

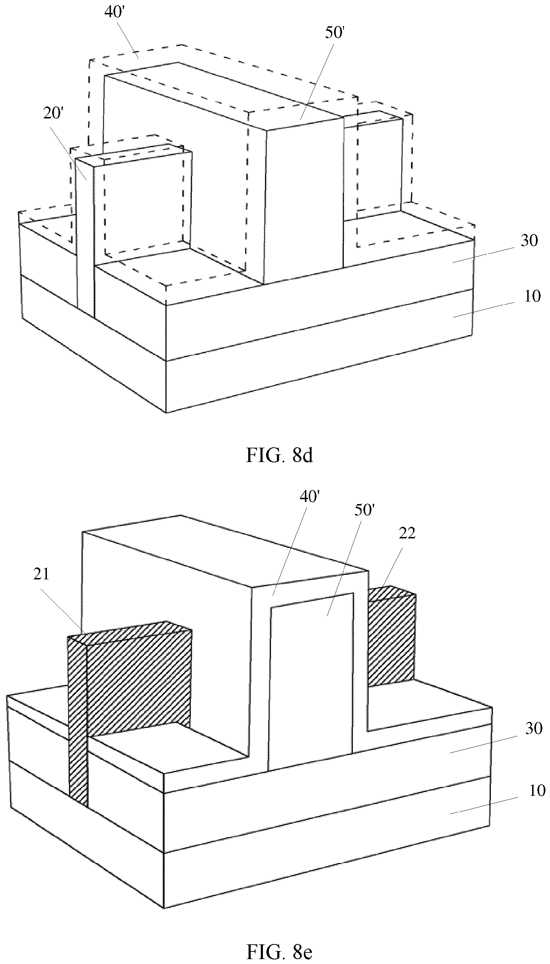

Refer to FIG. 8d. A sidewall material layer 40' (a film layer shown by a dashed line in FIG. 8d) covering the sacrificial gate 50' and the first dielectric layer 30 is formed.

The sidewall material layer may be formed by a dielectric material such as silicon monoxide (SiO), silicon nitride (SiN), or silicon oxynitride (SiON).

The sidewall material layer 40' located on two sides of the sacrificial gate 50' is generally referred to as sidewalls 40.

Refer to FIG. 8e. A source 21 and a drain 22 are respectively formed in a source region and a drain region of the initial fin 20'.

In this application, a part of the initial fin 20' located between the source 21 and the drain is a channel 23. The source 21, the drain 22, and the channel 23 are generally collectively referred to as a fin.

The source and the drain may be formed by an ion implantation process, or may be formed by epitaxy. This is not limited herein.

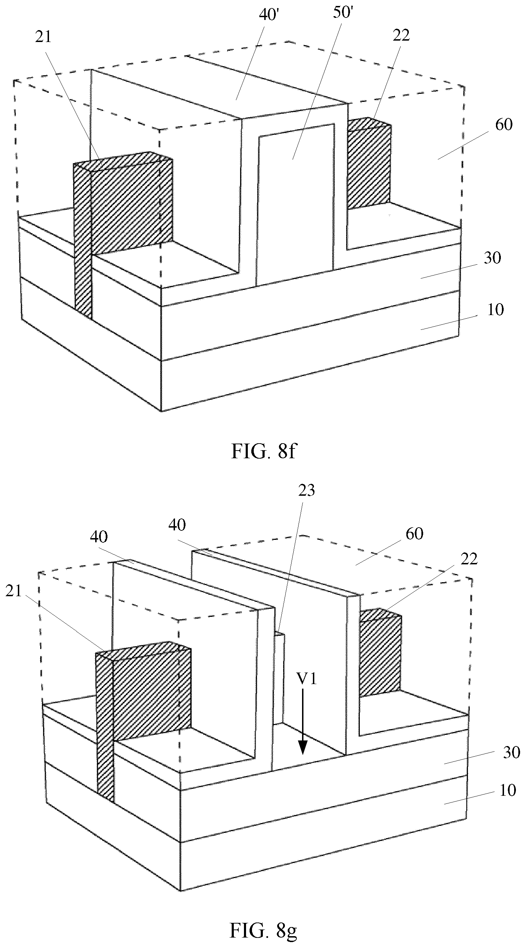

Refer to FIG. 8f. Filling of the second dielectric layer 60 is performed.

For example, the second dielectric layer may be formed by SiO, SiN, SiON, or another dielectric material.

Refer to FIG. 8g. The sacrificial gate 50' and the sidewall material layer 40' located on the sacrificial gate 50' are removed, so that a trench V1 is formed between the two sidewalls 40, and the channel 23 is exposed.

Then, the forming a gate structure in the trench may include the following steps.

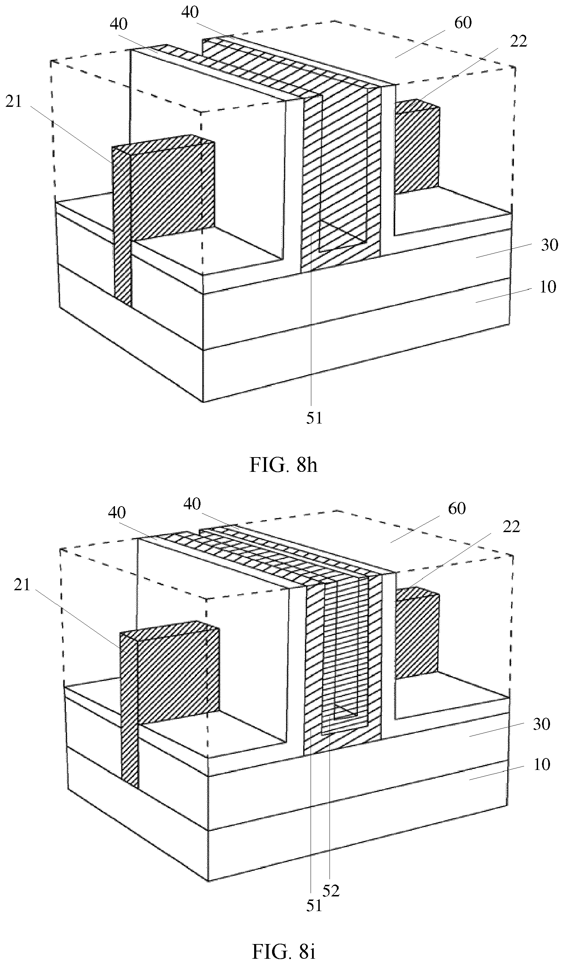

Step S102: As shown in FIG. 8h, form a gate dielectric layer 51 on side surfaces and a bottom surface of the trench defined by the sidewalls 40.

For example, the gate dielectric layer may be formed by a deposition process such as chemical vapor deposition, plasma enhanced chemical vapor deposition, atomic layer deposition, or another suitable deposition process by using a material such as hafnium oxide (HfO₂), zirconium oxide (ZrO₂), hafnium zirconium oxide (HfZrO₂), aluminum oxide (Al₂O₃), or silicon dioxide (SiO₂).

Optionally, the gate dielectric layer may further include a dipole layer, where the dipole layer includes element lanthanum (La) and element aluminum (Al).

Optionally, step S103 may further be included. Refer to FIG. 8i. A work function layer 52 is formed on side surfaces and a bottom surface of the gate dielectric layer 51.

For example, the work function layer may be formed by using at least one material in titanium nitride (TiN), titanium aluminum carbide (TiAlC), titanium aluminum nitride (TiAlN), and TiSiN. The work function layer may be formed by, for example, physical vapor deposition, chemical vapor deposition, plasma enhanced chemical vapor deposition, atomic layer deposition, or another suitable deposition process.

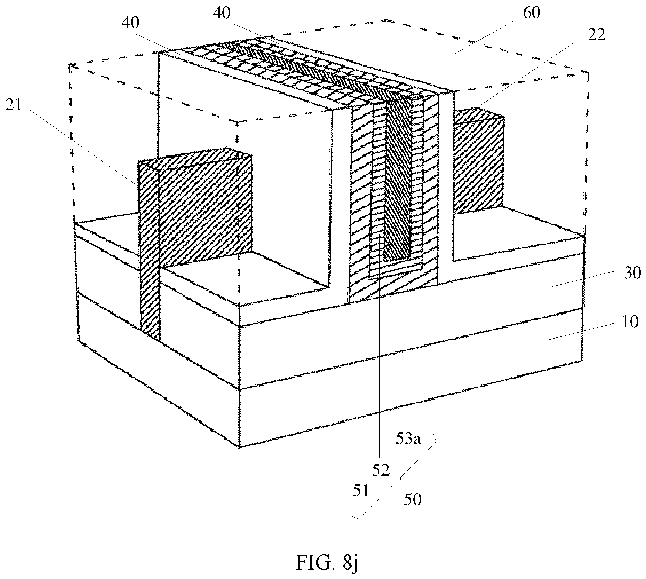

Step S104: As shown in FIG. 8j, form a gate metal layer in a gap defined by the work function layer 52, where the gate metal layer includes a TiSiN layer 53a.

In a feasible implementation, a substrate on which the gate metal layer is to be formed may be placed in an atomic layer deposition chamber, a precursor of titanium and a precursor of nitrogen are alternately provided into the atomic layer deposition chamber, and a precursor of silicon is continuously provided into the atomic layer deposition chamber, to form a titanium silicon nitride layer in the gap defined by the work function layer.

For example, the substrate on which the gate metal layer is to be formed is placed in the atomic layer deposition chamber, and the TiSiN layer may be formed, through at least one process cycle, in the gap defined by the work function layer.

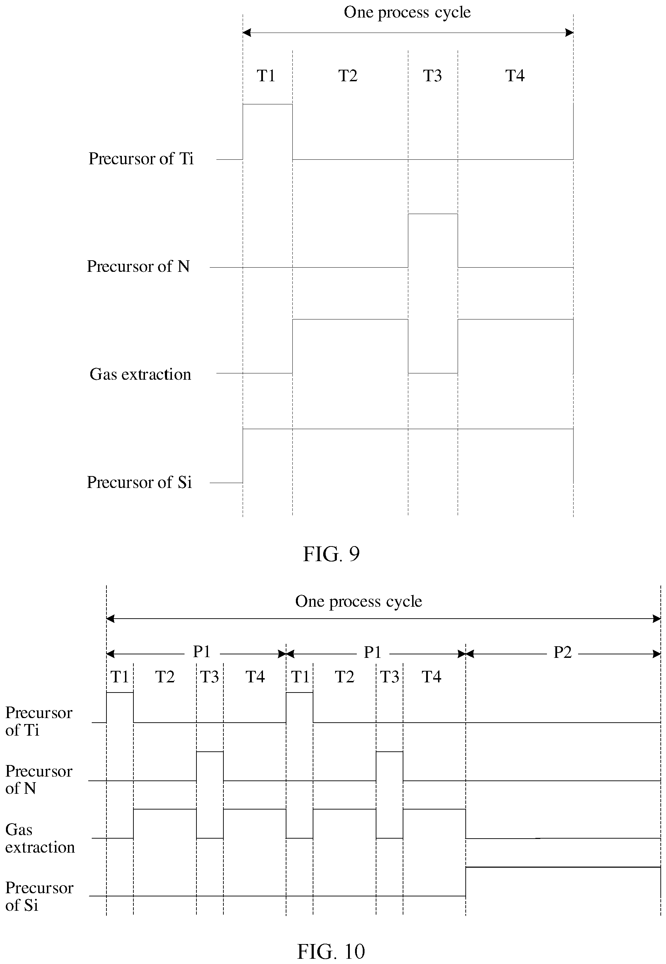

FIG. 9 is a sequence diagram of a process cycle during forming of a TiSiN layer according to this application. As shown in FIG. 9, one process cycle may include four stages T1 to T4.

At stage T1, a first precursor and a precursor of silicon (Si) are provided into an atomic layer deposition chamber.

It may be understood that the "precursor" in this application is a precursor or a raw material for synthesizing a target substance (that is, TiSiN), that is, an atomic layer deposition reaction source.

At stage T1, the first precursor may be a precursor of titanium (Ti) or a precursor of nitrogen (N). In FIG. 9, an example in which the first precursor is a precursor of Ti is used for illustration.

For example, the precursor of Ti may include at least one of titanium tetrachloride (TiCl₄), tetrakis (dimethylamino)titanium (C₂H₇NTi, TDMAT), or tetrakis (diethylamido)titanium (C₁₆H₄₀N₄Ti, TDEAT).

For example, the precursor of N may include at least one of ammonia (NH₃), nitrogen (N₂), nitrogen (N₂)-H₂ plasma, NH₃ plasma, or N₂ plasma.

For example, the precursor of Si may include at least one of silane (SiH₄), disilane (Si₂H₆), dichlorosilane (SiH₂Cl, DCS), or hexachlorodisilane (Si₂Cl₆, HCD).

At stage T2, the precursor of Si is provided into the atomic layer deposition chamber, and the first precursor is removed from the atomic layer deposition chamber.

In specific implementation, the first precursor may be removed from the atomic layer deposition chamber by gas extraction.

At stage T3, a second precursor and the precursor of Si are provided into the atomic layer deposition chamber.

At stage T3, the second precursor may be a precursor of N or a precursor of Ti. In FIG. 9, an example in which the second precursor is a precursor of N is used for illustration. At stage T4, the precursor of Si is provided into the atomic layer deposition chamber, and the second precursor is removed from the atomic layer deposition chamber.

In specific implementation, the second precursor may be removed from the atomic layer deposition chamber by gas extraction.

In this application, in a process cycle, at stage T1 to stage T4, the precursor of Si needs to be continuously provided into the atomic layer deposition chamber.

In FIG. 9, in a waveform corresponding to a precursor, a peak indicates that the precursor is provided into the atomic layer deposition chamber, a valley indicates that the precursor is not provided into the atomic layer deposition chamber. In a waveform corresponding to gas extraction, a peak indicates that gas extraction is performed, and a valley indicates that gas extraction is not performed.

In this application, duration of each stage in a process cycle needs to be configured based on an actual component and specific process conditions, and is not limited herein. Duration T1 to duration T4 in FIG. 9 are merely used for illustration, and are not specifically limited herein.

For example, in this application, a flow rate of the precursor of Si flowing into the atomic layer deposition chamber may be set to be less than or equal to 20% of that of the precursor of Ti, to ensure that content of Si in formed TiSiN is low.

In this embodiment, during forming of the TiSiN layer, the precursor of Si flows in continuously. Because the precursor of Si is a reducing gas, if Cl exists in the precursor of Ti, the reducing gas that continuously flows in can effectively reduce Cl in the precursor of Ti, thereby reducing resistivity of the TiSiN layer.

In another feasible implementation, a substrate on which a gate metal layer is to be formed may be placed in an atomic layer deposition chamber, and a precursor of titanium, a precursor of nitrogen, and a precursor of silicon are provided into the atomic layer deposition chamber, to form a titanium silicon nitride layer in a gap defined by the work function layer.

For example, the TiSiN layer may be formed, through at least one process cycle, in the gap defined by the work function layer.

FIG. 10 is a sequence diagram of a process cycle during forming of a TiSiN layer according to this application. As shown in FIG. 10, one process cycle may include at least one first process sub-cycle P1 and one second process sub-cycle P2 after the at least one process sub-cycle P1. In FIG. 10, an example in which one process cycle includes two P1 and one P2 is used for illustration.

In this application, one first process sub-cycle P1 may include four stages T1 to T4.

At stage T1, a first precursor is provided into the atomic layer deposition chamber.

At stage T1, the first precursor may be a precursor of titanium (Ti) or a precursor of nitrogen (N). In FIG. 10, an example in which the first precursor is a precursor of Ti is used for illustration.

For example, the precursor of Ti may include at least one of TiCl₄, C₂H₇NTi (TDMAT), or C₁₆H₄₀N₄Ti (TDEAT).

For example, the precursor of N may include at least one of NH₃, N₂, N₂-H₂ plasma, NH₃ plasma, or N₂ plasma.

At stage T2, the first precursor is removed from the atomic layer deposition chamber.

In specific implementation, the first precursor may be removed from the atomic layer deposition chamber by gas extraction.

At stage T3, a second precursor is provided into the atomic layer deposition chamber.

At stage T3, the second precursor may be a precursor of N or a precursor of Ti. In FIG. 10, an example in which the second precursor is a precursor of N is used for illustration.

At stage T4, the second precursor is removed from the atomic layer deposition chamber.

In specific implementation, the second precursor may be removed from the atomic layer deposition chamber by gas extraction.

In this application, one second process sub-cycle P2 may include: providing a precursor of Si into the atomic layer deposition chamber.

For example, the precursor of Si may include at least one of SiH₄, Si₂H₆, SiH₂Cl (DCS), or Si₂Cl₆ (HCD).

In FIG. 10, in a waveform corresponding to a precursor, a peak indicates that the precursor is provided into the atomic layer deposition chamber, a valley indicates that the precursor is not provided into the atomic layer deposition chamber. In a waveform corresponding to gas extraction, a peak indicates that gas extraction is performed, and a valley indicates that gas extraction is not performed.

In this application, duration of each stage in a process cycle needs to be configured based on an actual component and specific process conditions, and is not limited herein. Duration of T1 to T4 and P2 in FIG. 10 is merely used for illustration, and does not specifically constitute a limitation on duration.

In this application, when the Fin FET to be formed is a short-channel FET, the gate metal layer includes only a TiSiN layer. In other words, the gap defined by the work function layer is completely filled with the TiSiN layer.

When the Fin FET to be formed is a long-channel FET, forming the gate metal layer in the gap defined by the work function layer may further include: after a titanium silicon nitride layer is formed, forming a metal filling layer in the gap defined by the titanium silicon nitride layer. In other words, the gate metal layer includes the TiSiN layer and the metal filling layer.

In specific implementation, during production of the gate structure, in addition to being formed in the trench, film layers such as the gate dielectric layer, the work function layer, and the gate metal layer in the gate structure are further formed on a surface of the second dielectric layer. Therefore, after filling of the gate metal layer is completed, the gate metal layer, the work function layer, and the gate dielectric layer that are located above the second dielectric layer further need to be removed by a chemical mechanical polishing (Chemical Mechanical Polishing, CMP) process, so that only the gate dielectric layer, the work function layer, and the gate metal layer in the trench are retained. In this application, because the gate metal layer can implement seamless filling, grinding fluid in the chemical mechanical polishing process can be prevented from flowing into the work function layer, thereby preventing drift of a threshold voltage of the semiconductor chip.

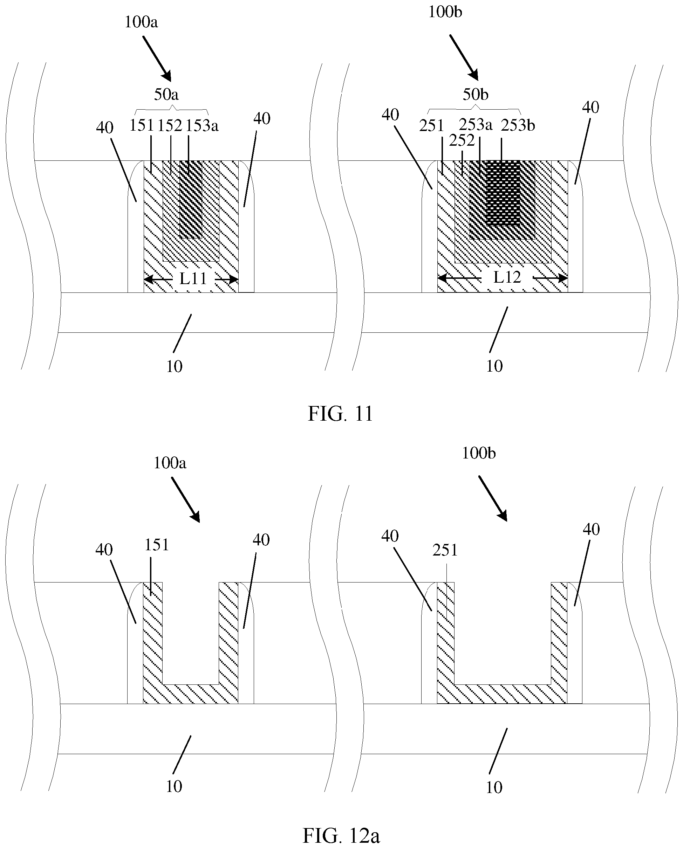

In the semiconductor chip provided in this application, both a short-channel Fin FET and a long-channel Fin FET may be provided. FIG. 11 is a schematic diagram of a cross-sectional structure of a semiconductor chip according to an embodiment of this application. The semiconductor chip includes a first Fin FET 100a and a second Fin FET 100b. The first Fin FET 100a is a short-channel FET, and the second Fin FET 100b is a long-channel FET.

In this application, a channel length of the first Fin FET 100a is less than or equal to 30 nm, and a channel length of the second Fin FET 100b is greater than or equal to 100 nm. Refer to FIG. 11. A length L11 of a gate structure 50a of the first Fin FET 100a is approximately equal to the channel length of the first Fin FET 100a, and a length L12 of a gate structure 50b of the second Fin FET 100b is approximately equal to the channel length of the second Fin FET 100b.

For example, the channel length of the first Fin FET may be controlled to be between 18 nm and 30 nm, and the channel length of the second Fin FET may be controlled between 100 nm and 300 nm.

For example, still refer to FIG. 11. The gate structure 50a of the first Fin FET 100a includes a gate dielectric layer 151, a work function layer 152, and a TiSiN layer 153a. The gate structure 50b of the second Fin FET 100b includes a gate dielectric layer 251, a work function layer 252, a TiSiN layer 253a, and a metal filling layer 253b. That is, the gate structure 50a of the first Fin FET 100a implements gap-free filling by using the TiSiN layer 153a, and the gate structure 50b of the second Fin FET 100b implements gap-free filling by using the metal filling layer 253b.

Optionally, the TiSiN layer 253a in the gate structure 50b of the second Fin FET 100b is formed by a same material as the TiSiN layer 153a in the gate structure 50a of the first Fin FET 100a. In this way, during production, the TiSiN layer 253a in the gate structure 50b of the second Fin FET 100b and the TiSiN layer 153a in the gate structure 50a of the first Fin FET 100a may be formed in a same process, thereby reducing process steps.

In this application, in the gate structure of the first Fin FET and the gate structure of the second Fin FET, other film layers (for example, the gate dielectric layer, a cover layer, a barrier layer, or the work function layer) than the gate metal layer may be configured to be the same or different. This needs to be designed based on components, and is not limited herein.

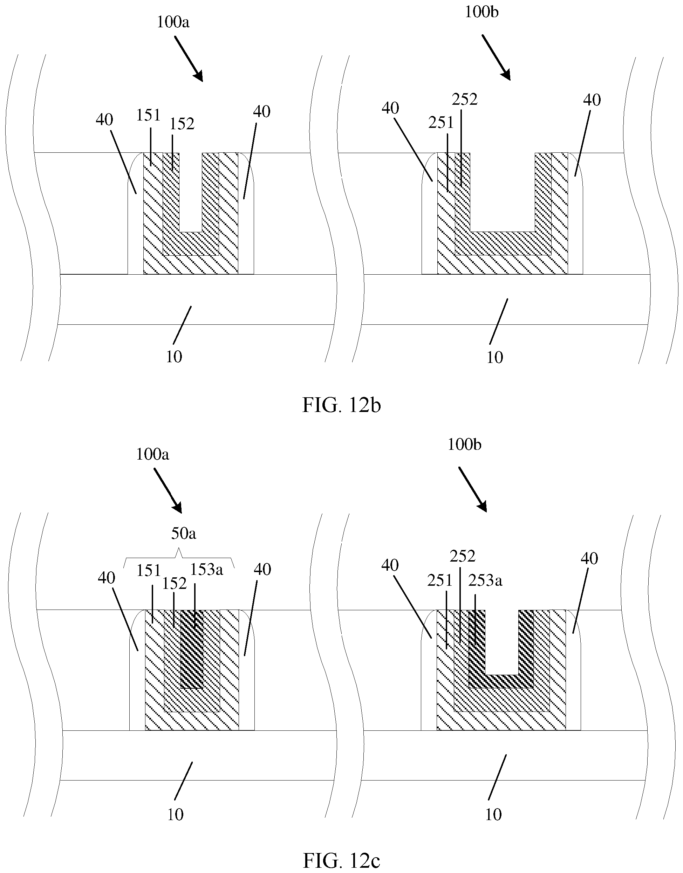

For example, in the gate structure 50a of the first Fin FET 100a and the gate structure 50b of the second Fin FET 100b, other film layers than the gate metal layer are all the same. During production, as shown in FIG. 12a, the gate dielectric layer 151 of the first Fin FET 100a and the gate dielectric layer 251 of the second Fin FET 100b may be formed at the same time; next, as shown in FIG. 12b, the work function layer 152 of the first Fin FET 100a and the work function layer 152 of the second Fin FET 100b are formed at the same time; as shown in FIG. 12c, the TiSiN layer 153a of the first Fin FET 100a and the TiSiN layer 253a of the second Fin FET 100b are then formed at the same time, where the TiSiN layer 153a of the first Fin FET 100a completely fills a gap, and there is a gap in the TiSiN layer 253a of the second Fin FET 100b; and as shown in FIG. 11, a metal filling layer 253b is finally formed in the gap of the TiSiN layer 253a of the second Fin FET 100b.

For example, in the gate structure of the second Fin FET, a material of the metal filling layer may include tungsten, cobalt, or ruthenium, and is not limited herein.

This application further provides an electronic device. The electronic device includes a circuit board and a chip. The chip includes any semiconductor chip according to embodiments of this application. The semiconductor chip is electrically connected to the circuit board. A problem-resolving principle of the electronic device is similar to that of the foregoing semiconductor chip. Therefore, for implementation of the electronic device, refer to the implementation of the foregoing semiconductor chip. Details are not described herein again.

It is clear that a person skilled in the art can make various modifications and variations to this application without departing from the protection scope of this application. This application is intended to cover these modifications and variations of this application provided that they fall within the scope of protection defined by the claims of this application and their equivalent technologies.

## Claims

1. A semiconductor chip, comprising a substrate and a first fin field-effect transistor Fin FET located on the substrate, wherein the first Fin FET comprises: a fin, two sidewalls that extend across the fin and are arranged opposite to each other, and a gate structure located in a trench defined by the two sidewalls; and
the gate structure comprises a gate dielectric layer and a gate metal layer that are stacked in sequence, the gate metal layer comprises a titanium silicon nitride layer, the gate dielectric layer is formed on side surfaces and a bottom surface of the trench, and the gate metal layer fills a gap defined by the gate dielectric layer.

2. The semiconductor chip according to claim 1, wherein Si %/(Si % + Ti %) <_ 10% in the titanium silicon nitride layer, wherein Si % represents a percentage of atomic concentration of silicon in the titanium silicon nitride layer, and Ti % represents a percentage of atomic concentration of titanium in the titanium silicon nitride layer.

3. The semiconductor chip according to claim 2, wherein 0.8 ≤ (Si % + Ti %)/N % ≤ 1.3 in the titanium silicon nitride layer, wherein N % represents a percentage of atomic concentration of nitrogen in the titanium silicon nitride layer.

4. The semiconductor chip according to any one of claims 1 to 3, wherein the gate structure further comprises a work function layer located between the gate dielectric layer and the gate metal layer.

5. The semiconductor chip according to any one of claims 1 to 4, wherein the gate metal layer further comprises a metal filling layer located in a gap defined by the titanium silicon nitride layer.

6. The semiconductor chip according to claim 5, wherein a material of the metal filling layer comprises tungsten, cobalt, or ruthenium.

7. The semiconductor chip according to any one of claims 1 to 6, wherein the fin comprises a source, a drain, and a channel; and the source and the drain are respectively located on two sides of the two sidewalls, and the channel is located between the source and the drain.

8. The semiconductor chip according to any one of claims 1 to 4, wherein the semiconductor chip further comprises a second Fin FET, and a gate structure of the second Fin FET comprises a gate dielectric layer, a work function layer, and a gate metal layer that are stacked in sequence;
the gate metal layer comprises a titanium silicon nitride layer and a metal filling layer that is located in a gap defined by the titanium silicon nitride layer; and
the first Fin FET is a short-channel FET, and the second Fin FET is a long-channel FET.

9. The semiconductor chip according to claim 8, wherein a channel length of the first Fin FET is less than or equal to 30 nm, and a channel length of the second Fin FET is greater than or equal to 100 nm.

10. The semiconductor chip according to claim 8 or 9, wherein a material of the silicon titanium silicon nitride layer in the gate structure of the second Fin FET is the same as a material of the silicon titanium silicon nitride layer in the gate structure of the first Fin FET.

11. The semiconductor chip according to any one of claims 8 to 10, wherein a material of the metal filling layer in the gate structure of the second Fin FET comprises tungsten, cobalt, or ruthenium.

12. The semiconductor chip according to any one of claims 1 to 11, wherein the semiconductor chip further comprises a first dielectric layer and a second dielectric layer, the first dielectric layer is located between the gate structure and the substrate and covers a surface of the substrate and a part of each side surface of the fin; and the second dielectric layer is located above the first dielectric layer, and the second dielectric layer covers a top and side surfaces of the fin that are exposed at outer sides of the sidewalls.

13. An electronic device, comprising a circuit board and the semiconductor chip according to any one of claims 1 to 12, wherein the semiconductor chip is electrically connected to the circuit board.

14. A semiconductor chip production method, comprising:
forming, on a substrate, a fin and two sidewalls that extend across the fin and are arranged opposite to each other;
forming a gate dielectric layer on side surfaces and a bottom surface of the trench defined by the two sidewalls; and
forming a gate metal layer in a gap defined by the gate dielectric layer, wherein the gate metal layer comprises a titanium silicon nitride layer.

15. The production method according to claim 14, wherein the forming a gate metal layer in a gap defined by the gate dielectric layer comprises:
placing, in an atomic layer deposition chamber, a substrate on which the gate metal layer is to be formed, alternately providing a precursor of titanium and a precursor of nitrogen into the atomic layer deposition chamber, and continuously providing a precursor of silicon to the atomic layer deposition chamber, to form the titanium silicon nitride layer in the gap defined by the gate dielectric layer.

16. The production method according to claim 15, wherein the substrate on which the gate metal layer is to be formed is placed in the atomic layer deposition chamber to form, through at least one process cycle, the titanium silicon nitride layer in the gap defined by the gate dielectric layer; and
one process cycle comprises:
providing a first precursor and the precursor of silicon into the atomic layer deposition chamber;
providing the precursor of silicon into the atomic layer deposition chamber, and removing the first precursor from the atomic layer deposition chamber;
providing a second precursor and the precursor of silicon into the atomic layer deposition chamber; and
providing the precursor of silicon into the atomic layer deposition chamber, and removing the second precursor from the atomic layer deposition chamber, wherein
the first precursor is the precursor of titanium, and the second precursor is the precursor of nitrogen; or the first precursor is the precursor of nitrogen, and the second precursor is the precursor of titanium.

17. The production method according to claim 15 or 16, wherein the flow rate of the precursor of silicon is less than 20% of the flow rate of the precursor of titanium.

18. The production method according to claim 14, wherein the forming a gate metal layer in a gap defined by the gate dielectric layer comprises:
placing, in an atomic layer deposition chamber, a substrate on which the gate metal layer is to be formed, providing a precursor of titanium, a precursor of nitrogen, and a precursor of silicon into the atomic layer deposition chamber, to form the titanium silicon nitride layer in the gap defined by the gate dielectric layer.

19. The production method according to claim 18, wherein the substrate on which the gate metal layer is to be formed is placed in the atomic layer deposition chamber to form, through at least one process cycle, the titanium silicon nitride layer in the gap defined by the gate dielectric layer;
one process cycle comprises at least one first process sub-cycle and one second process sub-cycle after the at least one process sub-cycle; and
one first process sub-cycle comprises:
providing a first precursor into the atomic layer deposition chamber;
removing the first precursor from the atomic layer deposition chamber;
providing a second precursor into the atomic layer deposition chamber; and
removing the second precursor from the atomic layer deposition chamber, wherein
the first precursor is the precursor of titanium, and the second precursor is the precursor of nitrogen; or the first precursor is the precursor of nitrogen, and the second precursor is the precursor of titanium; and
the second process sub-cycle comprises: providing the precursor of silicon into the atomic layer deposition chamber.

20. The production method according to any one of claims 15 to 19, wherein the precursor of titanium comprises at least one of titanium tetrachloride, tetrakis (dimethylamino)titanium, or tetrakis (diethylamido)titanium;
the precursor of nitrogen comprises at least one of ammonia, nitrogen, nitrogen-hydrogen plasma, nitrogen plasma, or ammonia plasma; and
the precursor of silicon comprises at least one of silane, disilane, dichlorosilane, or hexachlorodisilane.

21. The production method according to any one of claims 15 to 20, wherein the forming a gate metal layer in a gap defined by the gate dielectric layer further comprises:
after the titanium silicon nitride layer is formed, forming a metal filling layer in a gap defined by the titanium silicon nitride layer.
